# EUROPEAN PATENT APPLICATION

(11) **EP 4 580 320 A1**
(43) Date of publication of application: **02.07.2025**
(21) Application number: 24177666.5
(22) Date of filing: 23.05.2024
(51) Int. Cl.: H05K 1/02, H05K 3/42, H05K 3/40, H05K 1/11, G09F 9/33, H01L 25/075, H05K 3/00

(54) **LED MODULE HAVING THROUGH CHANNELS AND CONFORMING TO CERTIFICATION STANDARDS OF DCI AND DISPLAY SCREEN**

(30) Priority: 26.12.2023 CN 202311835220
(71) Applicant: Nanjing Lopu Co Ltd, Jiangbei New District Nanjing, Jiangsu 210061 (CN); Nanjing Lopu Technology Co., Ltd., Jiangsu 210061 (CN)
(72) Inventor: ZHU, Bin, Jiangsu 210061 (CN); XU, Ning, Jiangsu 210061 (CN); GUO, Chengbing, Jiangsu 210061 (CN); CHEN, Lei, Jiangsu 210061 (CN); JI, Lili, Jiangsu 210061 (CN); JIANG, Lingling, Jiangsu 210061 (CN); LV, Shiming, Jiangsu 210061 (CN); HOFER, Christian, Jiangsu 210061 (CN)
(74) Representative: HGF

(57) **Abstract**

The present application relates to the technical field of LED display, and discloses an LED module having through channels and conforming to certification standards of DCI and a display screen. The LED module includes a printed circuit board, the printed circuit board being provided with a plurality of first through channels, an inner peripheral side wall of the first through channel being provided with a first conductive layer, both sides of the printed circuit board being respectively provided with a conductive edge corresponding to the first through channel one to one, the conductive edge being disposed around a peripheral side of the first through channel and connected to the first conductive layer, and the first conductive layer being disposed in a grounding manner; and a supporting structure, which is disposed opposite to the printed circuit board and tightly connected to the printed circuit board, and has a plurality of second through channels, the supporting structure having a second conductive layer, and the second conductive layer being grounded and abutting against the conductive edge. The present application solves the problems for reducing blockage of the LED screen on sound and having a risk of data leakage.

## Description

The present application claims priority to Chinese Patent Application No. 2023118352201, filed to the China Patent Office on December 26, 2023 and entitled "LED MODULE HAVING THROUGH CHANNELS AND CONFORMING TO CERTIFICATION STANDARDS OF DCI AND DISPLAY SCREEN", the entire content of which is incorporated herein by reference.

### TECHNICAL FIELD

The present application relates to the technical field of LED display, and particularly relates to an LED module having through channels and conforming to certification standards of DCI and a display screen.

### BACKGROUND

In the traditional commercial theater industry, the playing facility in a theater is usually used for playing a picture by cooperating a projection apparatus with a projection screen. As the technology develops, due to its higher brightness, better clarity, and low requirements for ambient brightness, the LED screen technology gradually emerges in the market. An apparatus for playing commercial movies needs to meet the strict compliance test plan (CTP) requirement of international digital cinema initiatives (DCI), so as to achieve the purposes of protecting the digital film copyright and ensuring the audio-visual experience of the theater. In addition, the playing facility in a theater needs to meet the requirements of corresponding provisions of federal information processing standards (FIPS) in DCI, thereby achieving corresponding purposes of preventing signal leakage and guaranteeing data security.

Accompanied by video and audio reproduction, a film is played. In order to guarantee the audio-visual experience, audio in the film needs to be restored through a center-channel speaker behind a screen, which thus requires the screen to minimize the loss of a volume and sound quality when sound passes through the screen. In the prior art, it is usually to form holes in an LED screen to reduce blockage on the sound, thereby reducing the loss of the sound quality and the volume.

The above solution for forming holes in the LED screen to reduce blockage on the sound in the prior art cannot meet requirements of corresponding provisions of FIPS, and has a risk of data leakage.

Therefore, the applicant proposes a solution to form through channels on an LED printed circuit board, and dispose a metallized conductive layer on the inner side of the through channel, and at the same time, dispose a corresponding conductive layer on a supporting structure for mounting the LED printed circuit board, when the supporting structure and the LED printed circuit board are tightly mounted, the conductive layer of the supporting structure is made to abut against the metallized conductive layer on the inner side of the through channel to form an electrical connection, such that the two conductive layers form an equipotential body, thereby avoiding signal and electrical signal leakage and then reducing the risk of data leakage. However, the applicant has found in practice that, under the influence of factors such as the specific mounting situation, there may be a poor contact between the conductive layer of part of the through channel and the conductive layer of the supporting structure, resulting in the possibility that a signal is still detected in part of the through channel, which is still prone to the risk of data leakage.

### SUMMARY OF THE INVENTION

For this purpose, the present application provides an LED module having through channels and conforming to certification standards of DCI and a display screen to solve the problems for reducing blockage of the LED screen on sound and having a risk of data leakage, which also avoids the risk of data leakage caused by a poor contact.

In the first aspect, the present application provides an LED module, including a printed circuit board, one side of the printed circuit board being provided with a plurality of LED light-emitting diodes, the printed circuit board being provided with a plurality of first through channels, an inner peripheral side wall of the first through channel being provided with a first conductive layer, both sides of the printed circuit board being respectively provided with a conductive edge corresponding to the first through channel one to one, the conductive edge being laid in a direction from the periphery to the first through channel, extending to the first conductive layer and being electrically connected to the first conductive layer, and the first conductive layer being disposed in a grounding manner; and a supporting structure, which is suitable for supporting the printed circuit board and has a plurality of second through channels opposite to the first through channel one to one, the supporting structure having a second conductive layer, and the second conductive layer being grounded and abutting against the conductive edge.

Beneficial effect: By disposing the opposite first through channel and second through channel on the LED module, sound can pass through the through channel, thereby reducing a loss of sound quality and a volume. By disposing the first conductive layer on the inner peripheral side wall of the first through channel and making the first conductive layer connected to the second conductive layer of the supporting structure and grounded, each first conductive layer and the second conductive layer can form an equipotential body. When a signal probe extends into the first through channel and the second through channel, no signal can be detected no matter how to change a position and depth of the probe, thereby effectively avoiding the risk of data leakage, and making the module meet requirements of corresponding provisions of FIPS. At the same time, by disposing the conductive edge connected to the first conductive layer at an opening of the first through channel on board faces of both sides of the printed circuit board, the first conductive layer and the second conductive layer are kept being electrically connected when the supporting structure is tightly connected to the printed circuit board, such that the situation in which a local portion of the first conductive layer on the printed circuit board and the second conductive layer are unable to form an equipotential body due to the poor contact is greatly reduced, and the situation of a grounding failure of the first conductive layer is also avoided, thereby providing a reliable guarantee for data security. In addition, due to the fact that the LED module is provided with both the first through channel and the second through channel, the LED module has good heat dissipation and exhaust functions, thereby solving fire control and smoke discharge problems caused when the LED module is widely mounted on a building interior wall.

In one optimal implementation manner, the supporting structure is made of a conductive material to form the second conductive layer, or the surface of the supporting structure is metallized to form the second conductive layer.

Beneficial effects: The second conductive layer of the supporting structure can be formed by the supporting structure itself being made of the conductive material to have a conductive property, or can be formed by a conductive film made in manners of electroplating, deposition, film pasting and the like on the surface of the supporting structure made of a non-conductive material, so that components of the module have more optional solutions, which facilitates adapting to different working environments and meeting different device requirements.

In one optimal implementation manner, the LED module further comprises a mask layer, the mask layer is integrally disposed with the printed circuit board and located on a side of the printed circuit board away from the supporting structure, the first through channel extends and penetrates through the mask layer, the mask layer is made of a conductive material and electrically connected to the first conductive layer, and the LED light-emitting diode passes through the mask layer.

Beneficial effect: By disposing the mask layer to shelter and protect the surface of the printed circuit board having the LED light-emitting diode, since the mask layer and the printed circuit board are integrally disposed, the LED module can have a smaller thickness, thereby further reducing blockage on sound and improving quality of sound passing through the LED module.

In one optimal implementation manner, the LED module further comprises a mask layer, the mask layer is located on a side of the printed circuit board away from the supporting structure and tightly connected to the printed circuit board, the mask layer has a plurality of third through channels opposite to the first through channel one to one, the mask layer has a third conductive layer, the third conductive layer is grounded and abuts against the conductive edge, and the mask layer is provided with an avoiding groove for the LED light-emitting diode to pass through.

Beneficial effect: By disposing the mask layer to shelter and protect the surface of the printed circuit board having the LED light-emitting diode, split design of the mask layer and the printed circuit board makes component selection of the LED module have better flexibility, and facilitates overhauling the printed circuit board; the third through channel is aligned with the first through channel and the second through channel, which guarantees quality of sound passing through; at the same time, by disposing the third conductive layer and making the third conductive layer electrically connected to the first conductive layer and disposed in a grounding manner, the first conductive layer, the second conductive layer and the third conductive layer form a complete equipotential body, thereby making the whole LED module have a good signal shielding function, and further guaranteeing data security. Disposing the conductive edge also promotes a good contact between the third conductive layer and the first conductive layer, thereby further guaranteeing grounding stability of the first conductive layer.

In one optimal implementation manner, the mask layer is made of a metal material to form the third conductive layer, or the surface of the mask layer is metallized to form the third conductive layer.

Beneficial effect: The third conductive layer of the mask layer may be formed by the mask layer itself being made of a conductive material to have a conductive property, or can be formed by a conductive film made in manners of electroplating, deposition, film pasting and the like on the surface of the mask layer, so that components of the module have more optional solutions, which facilitates adapting to different working environments and meeting different device requirements.

In one optimal implementation manner, the printed circuit board is provided with a plurality of connection contacts, the plurality of connection contacts are distributed on a board face of one side of the printed circuit board, or the plurality of connection contacts are distributed on board faces of both sides of the printed circuit board, and the connection contact is suitable for abutting against the second conductive layer or the third conductive layer.

Beneficial effect: By disposing the connection contact on the surface of the printed circuit board to abut against the adjacent second conductive layer or third conductive layer, an electrical connection is formed between the printed circuit board and the mask layer or the supporting structure, or among the printed circuit board, the mask layer and the supporting structure, and the electrical connection is divided into single-point, multi-point or local electrical connections according to a specific structure and different distribution positions of the connection contact, thereby forming an equipotential body between the printed circuit board and the mask layer or the supporting structure, then making a structure of the equipotential body, capable of shielding an electrical signal, within the LED module more three-dimensional, substantially enhancing a signal shielding capability, and improving data security.

In one optimal implementation manner, a sectional shape of the first through channel is one of or a combination of a circle, a polygon, an ellipse, and a kidney shape.

Beneficial effect: By adopting one of or a combination of a circle, a polygon, an ellipse, and a kidney shape for the sectional shape of the first through channel, the first through channel is disposed on the printed circuit board with higher flexibility, which facilitates flexibly arranging a position and shape of the first through channel according to differences of LED light-emitting diodes, driving parts and circuits on different printed circuit boards, such that a ratio of a total area of the first through channel on the printed circuit board is increased as much as possible, thereby guaranteeing an amount of sound passing through and the sound quality.

In one optimal implementation manner, a ratio of a total area of the plurality of the first through channels to an area of the printed circuit board is 1%-30%.

Beneficial effect: By ensuring that the total area of the first through channel on the printed circuit board is 1%-30%, excessive blockage on sound from a center-channel speaker is avoided, thereby guaranteeing a total amount and quality of sound passing through while ensuring overall image quality.

In one optimal implementation manner, a side of the printed circuit board deviating from the LED light-emitting diode is provided with a driving element of the LED light-emitting diode, the supporting structure is provided with an accommodating groove at a position opposite to the driving element t, and the accommodating groove and the printed circuit board form an isolation space surrounding the driving element.

Beneficial effect: By disposing the accommodating groove for accommodating the driving element on the supporting structure, a wrapping structure enclosing the driving element is formed between the printed circuit board and the supporting structure, thereby avoiding a possibility of signal leakage caused by exposure of the driving element, and also avoiding a possibility of direct signal theft by a signal probe coming into contact with the driving element from the side of the supporting structure.

In one optimal implementation manner, a first trigger switch is disposed between the supporting structure and the printed circuit board.

Beneficial effect: By disposing the first trigger switch between the printed circuit board and the supporting structure, when LED module assembly is completed, the first trigger switch is in a state of being triggered and compressed by the printed circuit board and the supporting structure, and when the printed circuit board is illegally dismantled, the first trigger switch is triggered due to the loss of the compressed state, so as to adopt a method of making a control system forcibly interrupt signal transmission or send out an alarm, or the like to avoid data leakage caused when a structure is damaged.

In the second aspect, the present application further provides an LED display screen, including: a plurality of frame type box bodies, the frame type box body being a metal frame and disposed in a grounding manner, the plurality of frame type box bodies being mutually spliced in an array shape to form a display screen frame, and a length of a long side of the display screen frame being greater than or equal to 3 meters; a system electronic control box, which is mounted on an inner side of the frame type box body; and the above LED module, a plurality of LED modules being disposed and respectively connected to the frame type box body, the supporting structure being provided with a compressible conductive medium electrically connected to the second conductive layer, and the compressible conductive medium abutting against the frame type box body.

Beneficial effect: The frame type box body provides a mounting basis for the LED module, and because the frame type box body uses the metal frame, when the first conductive layer, the second conductive layer and the third conductive layer of the LED module are electrically connected to the frame type box body, the LED module and the frame type box body form a whole equipotential body structure, so as to have a whole function for preventing signal leakage; due to compressibility thereof, the compressible conductive medium can greatly reduce requirements of the LED module for mounting accuracy and improve adaptability between the LED module and the frame type box body. In addition, by forming the first through channel on the printed circuit board, a blocking effect on sound is reduced, so that sound of a center-channel speaker behind the screen can penetrate through the LED display screen to reach an audio play effect; compared to a manner of using a sound reflective panel and sound channel synthesis to simulate the center-channel speaker, in this technology, because an engineer does not need to individually design layout of a speaker and a sound channel according to the situation of a movie viewing venue, manufacturing cost is lower, and adaptability is better, especially when the movie viewing venue is large, it is impossible to use sound channel synthesis to simulate the center-channel speaker, but this technology can be applied to movie viewing venues in various sizes.

In one optimal implementation manner, the system electronic control box comprises a box cover and a box body which are hinged to each other, a safety prying-resistant lock is disposed between the box cover and the box body, and a second trigger switch is provided.

Beneficial effect: Hinged design of the box cover and the box body facilitates maintaining and overhauling the interior of the system electronic control box in the later period, and the safety prying-resistant lock can lower a possibility of illegal opening of the system electronic control box; and the second trigger switch makes a control system issue an alarm or interrupt signal transmission when the system electronic control box is illegally opened, which further enhances a data security performance of the LED screen.

In one optimal implementation manner, a sound-absorbing material is laid on each of a peripheral side inner wall of the frame type box body and a peripheral side wall of the system electronic control box.

Beneficial effect: By laying the sound-absorbing material inside the frame type box body, reflection of sound in the frame type box body can be effectively reduced, thereby reducing a distortion effect caused by reflection on sound and improving sound quality.

In one optimal implementation manner, a joint kit is disposed between the adjacent frame type box bodies, the joint kit penetrates through side walls of two adjacent frame type box bodies, and the joint kit is provided with a through hole penetrating through the two adj acent frame type box bodies; and the joint kit is made of a conductive material and electrically connected to the frame type box body.

Beneficial effect: By disposing the joint kit, a line between the adjacent frame type box bodies is wrapped and protected, and the joint kit penetrates from one frame type box body into another frame type box body and forms an electrical connection structure with the frame type box body, thereby forming an equipotential body with the frame type box body, further preventing signal leakage at a cable joint, and further providing a safeguard for data security.

In the third aspect, the present application further provides an LED dome screen, including a plurality of frame type box bodies, a frame plane of the frame type box body being in a hyperboloid shape, and the plurality of frame type box bodies being mutually spliced in an array shape to form a spherical display screen frame, and a diameter of the LED dome screen being greater than or equal to 3 meters; and the above LED module, a plurality of LED modules being disposed and respectively connected to the frame type box body, the supporting structure being provided with a compressible conductive medium electrically connected to the second conductive layer, and the compressible conductive medium abutting against the frame type box body.

Beneficial effect: The dome screen, also known as a ball-shaped screen, is a large cambered surface display screen, and for audio play of the dome screen, it is not able to use a manner of sound channel synthesis to simulate a center-channel speaker on a rear side or an inner side of the screen; and for the LED dome screen of this technology, first through channels are disposed to ensure quality of audio played by the center-channel speaker, thereby satisfying an audio restoration requirement in a dome screen use scenario and improving adaptability of a dome screen playing apparatus for a venue.

In the fourth aspect, the present application further provides an LED cambered screen, including a mounting frame; and a plurality of the above LED modules, the plurality of the LED modules being all mounted on the mounting frame and arranged in a cambered surface shape.

Beneficial effect: The LED modules are arranged in the cambered surface shape to form the cambered screen, which further enhances the diversity of screen use scenarios and applicable sites, and improves the practicality of the product.

### BRIEF DESCRIPTION OF THE DRAWINGS

To describe the technical solutions in specific implementation manners of the present application or the prior art more clearly, the following briefly describes the accompanying drawings required for describing the specific implementation manners or the prior art. Apparently, the accompanying drawings in the following description show only some implementation manners of the present application, and a person of ordinary skill in the art may still derive other accompanying drawings from the accompanying drawings without creative efforts.
FIG. 1 is a sectional view of a local structure of an LED module of an embodiment of the present application;
FIG. 2 is a schematic view of a local structure of an LED module of an embodiment of the present application for embodying a positional relationship and a structure among a printed circuit board, a mask layer and a supporting structure;
FIG. 3 is a schematic view of a local structure of an LED module of another embodiment of the present application for embodying a positional relationship and a structure among a printed circuit board, a mask layer and a supporting structure;
FIG. 4 is a schematic view of a cross-sectional structure of an LED module of an embodiment of the present application;
FIG. 5 is a schematic view of an LED module of an embodiment of the present application for detecting a signal in a through channel by means of a probe;
FIG. 6 is a schematic view of an overall structure of an LED screen of an embodiment of the present application;
FIG. 7 is a structural schematic view of a system electronic control box of an LED screen of an embodiment of the present application;
FIG. 8 is a schematic view of an LED screen of an embodiment of the present application for embodying a spliced structure of a plurality of frame type box bodies;
FIG. 9 is a schematic view of a sectional structure of an LED screen of an embodiment of the present application for embodying a structure of a joint kit on an end portion of a system electronic control box;
FIG. 10 is a schematic view of an LED screen of an embodiment of the present application for embodying a structure of a joint kit on an end portion of a conduit; and
FIG. 11 is a structural schematic view of an LED module of an embodiment of the present application for preventing signal leakage.

### List of Reference Numerals:

100: printed circuit board; 101: LED light-emitting diode; 102: driving element; 103: first through channel; 104: first conductive layer; 105: conductive edge; 106: connection contact; 200: supporting structure; 201: second through channel; 202: second conductive layer; 203: accommodating groove; 300: mask layer; 301: third through channel; 302: third conductive layer; 303: avoiding groove; 400: frame type box body; 500: system electronic control box; 501: safety prying-resistant lock; 502: box body; 503: box cover; 600: sound-absorbing material; 700: probe; 800: second trigger switch; 900: conduit; 901: joint kit; 1101: connector of the microswitch; 1102: rubber-coated steel wire rope.

### DETAILED DESCRIPTION

To make the objectives, technical solutions, and advantages of embodments of the present application clearer, the following clearly and completely describes the technical solutions in the embodiments of this application with reference to drawings in the embodiments of this application. Apparently, the described embodiments are some rather than all of the embodiments of this application. Based on the embodiments in the present application, all other embodiments obtained by those of skill in the art without creative effort fall within the protection scope of the present application.

With the development of the technology, an LED screen gradually replaces a projector and a projection screen to serve as a video playing apparatus of a commercial theater, as play of a film video is usually accompanied by play of audio, in the audio play process, it needs to rely on cooperation of a center-channel speaker and other speakers to achieve a high degree of sound reproduction and to satisfy an audio-visual effect.

However, because the LED screen is different from the projection screen, it will cause a more serious blocking effect on the sound, usually affecting a play effect of the center-channel speaker. In the related technology, part of commercial theaters use a manner of multi-sound channel synthesis to simulate a main sound channel of the center-channel speaker, for example, a manner of a screen reflecting surrounding sound channels to synthesize a main sound channel is used, but the loss of sound reflected by the scree is large, the effect is not good, at the same time, an engineer needs to perform customization for audio synthesis according to the size of a movie hall and the screen, such that cost is high, and when this method is used for a giant screen with a length of more than 16 meters, the requirement of the audio-visual experience of the theater in DCI cannot be guaranteed.

Another part of commercial theaters use an LED screen with perforations as a play apparatus, such that the sound emitted by the center-channel speaker can be transmitted through the perforations of the LED screen, however, this method will lead to signal leakage caused by the LED screen, which seriously affects data security and thus fails to meet the requirements of signal leakage provisions of FIPS in DCI.

Based on the above, the present application proposes an LED module and an LED display screen that have a wide range of applications, fewer limitations, and are capable of meeting requirements of DCI.

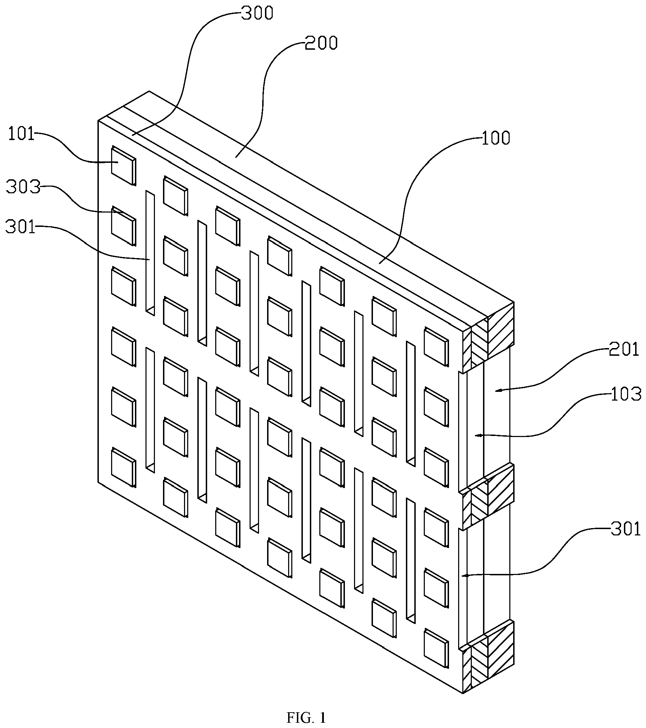

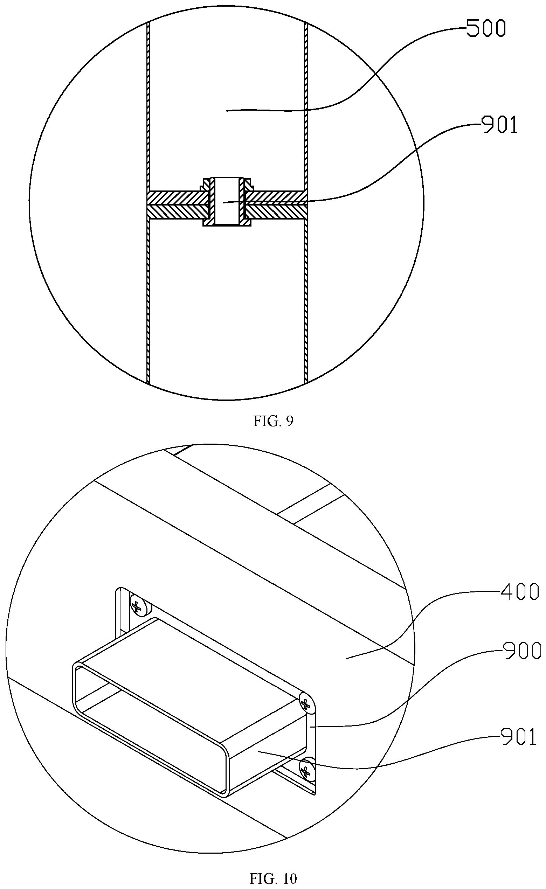

Embodiments of the present application are described below with reference to FIG. 1 to FIG. 10.

According to an embodiment of the present application, in one aspect, an LED module is provided, and please refer to FIG. 1 to FIG. 3, the LED module includes a printed circuit board 100 and a supporting structure 200, where one side of the printed circuit board 100 is provided with a plurality of LED light-emitting diodes 101, the printed circuit board 100 is provided with a plurality of first through channels 103, an inner peripheral side wall of the first through channel 103 is provided with a first conductive layer 104, both sides of the printed circuit board 100 are respectively provided with a conductive edge 105 corresponding to the first through channel 103, the conductive edge 105 is laid, in a direction from the periphery to the first through channel 103, to the first conductive layer 104 and is electrically connected to the first conductive layer 104, and the first conductive layer 104 is disposed in a grounding manner; and the supporting structure 200 is suitable for supporting the printed circuit board 100 and has a plurality of second through channels 201 opposite to the first through channel 103 one to one, the supporting structure 200 has a second conductive layer 202, and the second conductive layer 202 is grounded and abuts against the conductive edge 105.

Specifically, the LED light-emitting diodes 101 are distributed in an array and affixed to the surface of the printed circuit board 100. The conductive edge 105 is disposed around a channel opening of the first through channel 103 and completely surrounds the channel opening of the first through channel 103, and the conductive edge 105 at the same first through channel 103 extends along a circumferential trajectory of the first through channel 103 and is connected to the first conductive layer 104 to form a conductive whole. A shape and structure of the supporting structure 200 are the same as those of the printed circuit board 100, and the second through channel 201 has the same shape and size as the first through channel 103 and is disposed directly opposite to the first through channel 103.

It needs to be noted that the present embodiment does not limit the shape and size of the first through channel 103, and a sectional shape of the first through channel 103 may be in a shape of a slit, and in some embodiments not shown, a shape of the first through channel 103 may also be one of or a combination of a circle, a polygon, an ellipse, a kidney shape, or other irregular shapes. The first through channel 103 is disposed as much as possible on the basis of satisfying strength of the printed circuit board 100 and arrangement of a circuit, the LED light-emitting diode 101 and a driving element 102, so that a ratio of a total area of the first through channel 103 to an area of the printed circuit board 100 is increased as much as possible, thereby enhancing a volume and quality of sound that passes through the LED module.

It needs to be further noted that shapes of different first through channels 103 may be different or the same.

In the present embodiment, by disposing the opposite first through channel 103 and second through channel 201 on the LED module, sound can pass through the through channel, thereby reducing a loss of the sound quality and the volume. By disposing the first conductive layer 104 on the inner peripheral side wall of the first through channel 103 and making the first conductive layer 104 connected to the second conductive layer 202 of the supporting structure 200 and grounded, each first conductive layer 104 and the second conductive layer 202 can form an equipotential body. When a signal probe 700 extends into the first through channel 103 and the second through channel 201, no signal can be detected no matter how to change a position and depth of the probe 700, thereby effectively avoiding a risk of data leakage, and making the module meet requirements of corresponding provisions of FIPS. At the same time, by disposing the conductive edge 105 connected to the first conductive layer 104 at an opening of the first through channel 103 on board faces of both sides of the printed circuit board 100, the first conductive layer 104 and the second conductive layer 202 are kept being electrically connected when the supporting structure 200 is tightly connected to the printed circuit board 100, such that the situation in which a local portion of the first conductive layer 104 on the printed circuit board 100 and the second conductive layer 202 are unable to form an equipotential body due to the poor contact is greatly reduced, and the situation of a grounding failure of the first conductive layer 104 is also avoided, thereby providing a reliable guarantee for data security. In addition, due to the fact that the LED module is provided with both the first through channel 103 and the second through channel 201, the LED module has good heat dissipation and exhaust functions, thereby solving fire control and smoke discharge problems caused when the LED module is widely mounted on a building interior wall.

In one embodiment, the supporting structure 200 is made of a conductive material to form the second conductive layer 202, or the surface of the supporting structure 200 is metallized to form the second conductive layer 202.

In the present embodiment, the second conductive layer 202 of the supporting structure 200 can be formed by the supporting structure 200 itself being made of the conductive material to have a conductive property, or can be formed by a conductive film made in manners of electroplating, deposition, film pasting and the like on the surface of the supporting structure 200, so that components of the module have more optional solutions, which facilitates adapting to different working environments and meeting different device requirements.

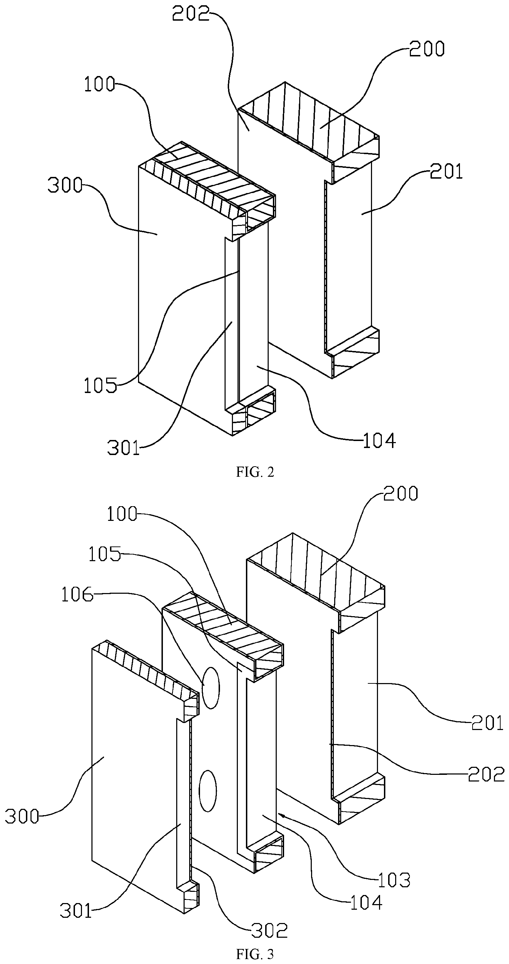

Please refer to FIG. 2, in one embodiment, the LED module further comprises a mask layer 300, the mask layer 300 is integrally disposed with the printed circuit board 100 and located on the side of the printed circuit board 100 away from the supporting structure 200, the first through channel 103 extends and penetrates through the mask layer 300, the mask layer 300 is made of a conductive material and electrically connected to the first conductive layer 104, and the LED light-emitting diode 101 passes through the mask layer 300.

Specifically, the mask layer 300 is made of a metal material and integrally disposed on the surface of the printed circuit board 100 in manners of film coating, coating and the like so as to be tightly connected to the conductive edge 105 and form an equipotential body. Exemplarily, the mask layer 300 is coated with copper to form a copper film on the surface of the printed circuit board 100. In addition, the side of the mask layer 300 away from the printed circuit board 100 is subjected to consistency treatment, so that indicators such as surface color and light absorption of the mask layer 300 meet requirements of the LED screen.

In the present embodiment, by disposing the mask layer 300 to shelter and protect the surface of the printed circuit board 100 having the LED light-emitting diode 101, since the mask layer 300 and the printed circuit board 100 are integrally disposed, the LED module can have a smaller thickness, thereby further reducing blockage on sound and improving quality of sound passing through the LED module.

Please refer to FIG. 3, in one embodiment, the LED module further comprises a mask layer 300, the mask layer 300 is located on the side of the printed circuit board 100 away from the supporting structure 200 and tightly connected to the printed circuit board 100, the mask layer 300 has a plurality of third through channels 301 opposite to the first through channel 103 one to one, the mask layer 300 has a third conductive layer 302, the third conductive layer 302 is grounded and abuts against the conductive edge 105, and the mask layer 300 is provided with an avoiding groove 303 for the LED light-emitting diode 101 to pass through.

In the present embodiment, by disposing the mask layer 300 to shelter and protect the surface of the printed circuit board 100 having the LED light-emitting diode 101, split design of the mask layer 300 and the printed circuit board 100 makes component selection of the LED module have better flexibility, and facilitates overhauling the printed circuit board 100; the third through channel 301 is aligned with the first through channel 103 and the second through channel 201, which guarantees quality of sound passing through; at the same time, by disposing the third conductive layer 302 and making the third conductive layer 302 electrically connected to the first conductive layer 104 and disposed in a grounding manner, the first conductive layer 104, the second conductive layer 202 and the third conductive layer 302 form a complete equipotential body, thereby making the whole LED module have a good signal shielding function, and further guaranteeing data security. Disposing the conductive edge 105 also promotes a good contact between the third conductive layer 302 and the first conductive layer 104, thereby further guaranteeing grounding stability of the first conductive layer 104.

In some of the above embodiments, the mask layer 300, the printed circuit board 100 and the supporting structure 200 are tightly coupled so that the overall thickness of the LED module is less than or equal to 5 millimeters, thereby making the LED module thinner and lighter and have a good sound transmission property.

In one embodiment, the mask layer 300 is made of a metal material to form the third conductive layer 302, or the surface of the mask layer 300 is metallized to form the third conductive layer 302.

In the present embodiment, the third conductive layer 302 of the mask layer 300 may be formed by the mask layer 300 itself being made of a conductive material to have a conductive property, or can be formed by a conductive film made in manners of electroplating, pasting or coating on the surface of the mask layer 300, so that components of the module have more optional solutions, which facilitates adapting to different working environments and meeting different device requirements.

In one embodiment, the printed circuit board 100 is provided with a plurality of connection contacts 106, the plurality of connection contacts 106 are distributed on a board face of one side of the printed circuit board 100, or the plurality of connection contacts 106 are distributed on board faces of both sides of the printed circuit board 100, and the connection contact 106 is suitable for abutting against the second conductive layer 202 or the third conductive layer 302.

Specifically, the connection contacts 106 may be distributed on a board face of one side of the printed circuit board 100 facing the mask layer 300, or may be distributed on a board face of one side of the printed circuit board 100 facing the supporting structure 200, and may also be distributed on board faces of both sides of the printed circuit board 100, and each connection contact 106 abuts against the second conductive layer 202 or the third conductive layer 302 that is directly opposite to the board face of the printed circuit board 100 on which the connection contact is located.

It needs to be noted that the present embodiment does not limit a specific shape of the connection contacts 106, and a sectional shape of the connection contact 106 may be disc-shaped, or in some embodiments not shown, may be polygonal, oval, irregular, and the like. In addition, the present embodiment does not limit a specific distribution form of the connection contact 106, and the connection contact 106 can be freely disposed according to a specific positional situation of the LED light-emitting diode 101 and a specific positional situation of the driving element 102.

In the present embodiment, by disposing the connection contact 106 on the surface of the printed circuit board 100 to abut against the adjacent second conductive layer 202 or third conductive layer 302, an electrical connection is formed between the printed circuit board 100 and the mask layer 300 or the supporting structure 200, or among the printed circuit board 100, the mask layer 300 and the supporting structure 200, and the electrical connection is divided into single-point, multi-point or local electrical connections according to a specific structure and different distribution positions of the connection contact 106, thereby forming an equipotential body between the printed circuit board 100 and the mask layer 300 or the supporting structure 200, then making a structure of the equipotential body, capable of shielding an electrical signal, within the LED module more three-dimensional, substantially enhancing a signal shielding capability, and improving data security.

In one embodiment, a sectional shape of the first through channel 103 is one of or a combination of a circle, a polygon, an ellipse, and a kidney shape.

In addition, specifically, a ratio of a total area of all the first through channels 103 to a total area of the surface of the printed circuit board 100 is 1% to 60%, and by adopting one of or a combination of a circle, a polygon, an ellipse, and a kidney shape for the sectional shape of the first through channel 103, the first through channel 103 is disposed on the printed circuit board 100 with higher flexibility, which facilitates flexibly arranging a position and shape of the first through channel 103 according to differences of the LED light-emitting diodes 101, driving parts and circuits on different printed circuit boards 100, such that the ratio of the total area of the first through channel 103 on the printed circuit boards 100 is increased as much as possible, thereby guaranteeing the amount of sound passing through and the quality of the sound. Exemplarily, the ratio of the total area of all the first through channels 103 to the total area of the surface of the printed circuit board 100 is 1% to 30%, and excessive blockage on sound from a center-channel speaker is avoided, thereby guaranteeing a total amount and quality of the sound passing through while ensuring overall image quality.

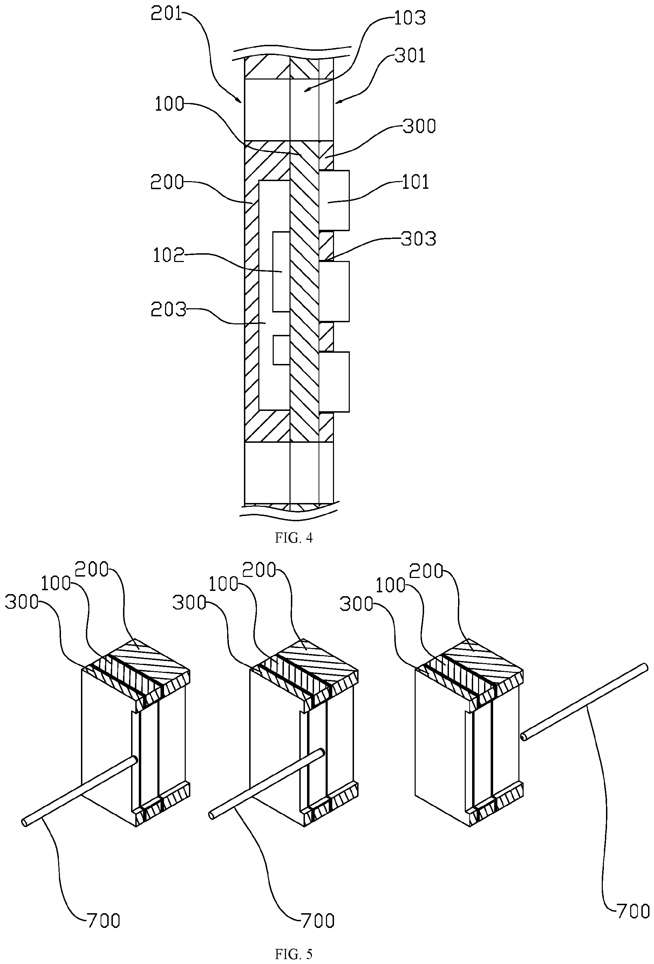

Please refer to FIG. 4 and FIG. 5, in one embodiment, a side of the printed circuit board 100 deviating from LED light-emitting diode 101 is provided with a driving element 102 of the LED light-emitting diode 101, the supporting structure 200 is provided with an accommodating groove 203 at a position opposite to the driving element 102, and the accommodating groove 203 and the printed circuit board 100 form an isolation space surrounding the driving element 102.

In the present embodiment, by disposing the accommodating groove 203 for accommodating the driving element 102 on the supporting structure 200, a wrapping structure enclosing the driving element 102 is formed between the printed circuit board 100 and the supporting structure 200, thereby avoiding a possibility of signal leakage caused by exposure of the driving element 102, and also avoiding a possibility of direct signal theft by a signal probe 700 coming into contact with the driving element 102 from the side of the supporting structure 200.

In one embodiment, a first trigger switch is disposed between the supporting structure 200 and the printed circuit board 100.

Specifically, a micro switch or an electrical contact switch may be selected as the first trigger switch, and the first trigger switch is electrically connected to a screen control system so as to send a signal to the screen control system. The first trigger switch may be mounted on the supporting structure 200 or may be mounted on the printed circuit board 100, and a specific mounting position of the first trigger switch on the supporting structure 200 or on the board face of the printed circuit board 100 is not limited.

In the present embodiment, by disposing the first trigger switch between the printed circuit board 100 and the supporting structure 200, when LED module assembly is completed, the first trigger switch is in a state of being triggered and compressed by the printed circuit board 100 and the supporting structure 200, and when the printed circuit board 100 is illegally dismantled, the first trigger switch is triggered due to the loss of the compressed state, so as to adopt a method of making the control system forcibly interrupt signal transmission or send out an alarm, or the like to avoid data leakage caused when a structure is damaged.

In some of the above embodiments, specifically, the conductive material may be copper, or other metallic materials, or other non-metallic materials capable of forming an electrostatic shielding layer, exemplarily, the non-metallic material may be a graphene material.

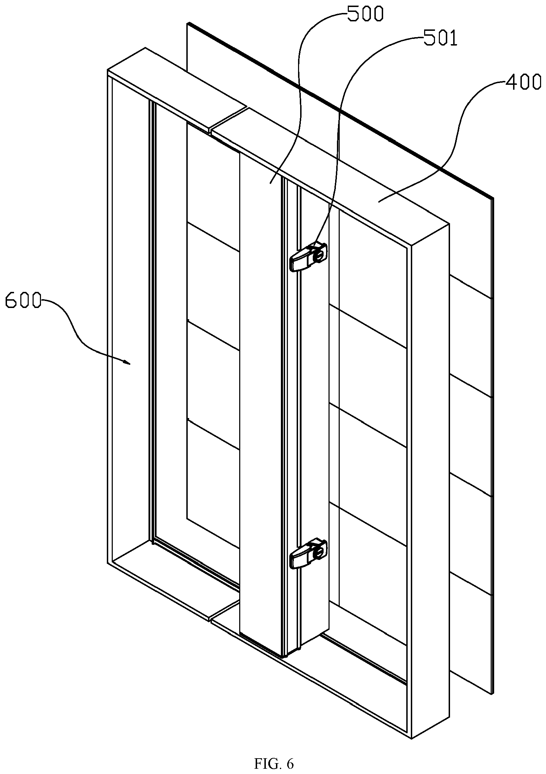

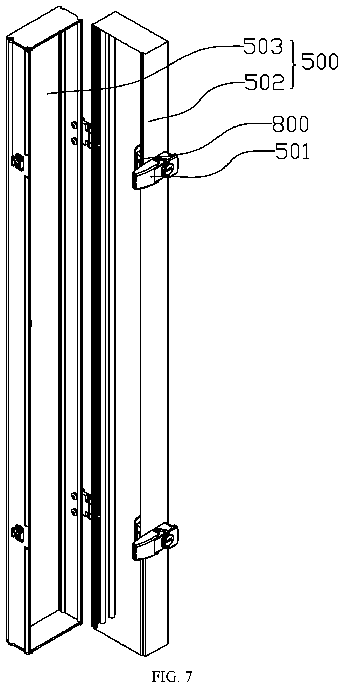

According to an embodiment of the present application, in another aspect, the present application further provides an LED display screen, please refer to FIG. 6 and FIG. 7, the LED display screen includes: a plurality of frame type box bodies 400, the frame type box body 400 being a metal frame and disposed in a grounding manner, the plurality of frame type box bodies 400 being mutually spliced in an array shape to form a display screen frame, and a length of a long side of the display screen frame being greater than or equal to 3 meters; a system electronic control box 500, which is mounted on an inner side of the frame type box body 400; and the above LED module, a plurality of LED modules being disposed and respectively connected to the frame type box body 400, the supporting structure 200 being provided with a compressible conductive medium electrically connected to the second conductive layer 202, and the compressible conductive medium abutting against the frame type box body 400.

Specifically, the frame type box body 400 is a metal box, and can use a profile frame or a sheet metal frame. The frame type box body 400 is disposed in a grounding manner and an inner side of the frame type box body 400 is provided with a plurality of grilles (not shown in the figure) for mounting the LED modules, on one hand, the grille provides a mounting basis for the LED module, and on the other hand, the grille facilitates that the LED module is disposed in a grounding manner by being electrically connected to the frame type box body 400.

It needs to be noted that the compressible conductive medium may be an elastic conductive sheet or other conductive part having elasticity.

In addition, specifically, a length of the LED display screen can be selected according to actual site needs, exemplarily, the length of the LED display screen is 10 meters, 16 meters, or 20 meters, and a length-width ratio of the LED display screen can be set according to site or industry specifications, exemplarily, the length-width ratio is 1.85: 1, or the length-width ratio is 2.35: 1.

In the present embodiment, the frame type box body 400 provides a mounting basis for the LED module, and because the frame type box body 400 uses a metal frame, when the first conductive layer 104, the second conductive layer 202 and the third conductive layer 302 of the LED module are electrically connected to the frame type box body 400, the LED module and the frame type box body 400 form a whole equipotential body structure, so as to have a whole function for preventing signal leakage; due to compressibility thereof, the compressible conductive medium can greatly reduce requirements of the LED module for the mounting accuracy and improve adaptability between the LED module and the frame type box body 400. In addition, by forming the first through channel 103 on the printed circuit board 100, the blocking effect on the sound is reduced, so that sound of a center-channel speaker behind the screen can penetrate through the LED display screen to reach an audio play effect; compared to a manner of using a sound reflective panel and sound channel synthesis to simulate the center-channel speaker, in this technology, because an engineer does not need to individually design layout of a loudspeaker and a sound channel according to the situation of a movie viewing venue, manufacturing cost is lower, and adaptability is better, especially when the movie viewing venue is large, it is impossible to use sound channel synthesis to simulate the center-channel speaker, but this technology can be applied to movie viewing venues in various sizes.

In one embodiment, the system electronic control box 500 comprises a box cover 503 and a box body 502 which are hinged to each other, a safety prying-resistant lock 501 is disposed between the box cover 503 and the box body 502, and a second trigger switch 800 is provided.

Specifically, the second trigger switch 800 may be a micro switch or an electrical contact switch, and the second trigger switch 800 is electrically connected to a screen control system. The second trigger switch 800 is disposed at the safety prying-resistant lock 501, and when the safety prying-resistant lock 501 is disengaged from a locking member on a cover body, the second trigger switch starts to work.

In the present embodiment, hinged design of the box cover 503 and the box body 502 facilitates maintaining and overhauling the interior of the system electronic control box 500 in the later period, and the safety prying-resistant lock 501 can lower a possibility of illegal opening of the system electronic control box 500; and the second trigger switch 800 makes a control system issue an alarm or interrupt signal transmission when the system electronic control box 500 is illegally opened, which further enhances a data security performance of the LED screen.

In one embodiment, a sound-absorbing material 600 is laid on each of a peripheral side inner wall of the frame type box body 400 and a peripheral side wall of the system electronic control box 500.

Specifically, the sound-absorbing material 600 can be sound-absorbing cotton or other materials that have a sound-absorbing effect.

In addition, it needs to be noted that, when the LED display screen is used in a theater, a movie server needs to be mounted behind the LED display screen to realize a movie play function.

In the present embodiment, by laying the sound-absorbing material 600 inside the frame type box body 400, reflection of sound in the frame type box body 400 can be effectively reduced, thereby reducing a distortion effect caused by reflection on sound and improving sound quality.

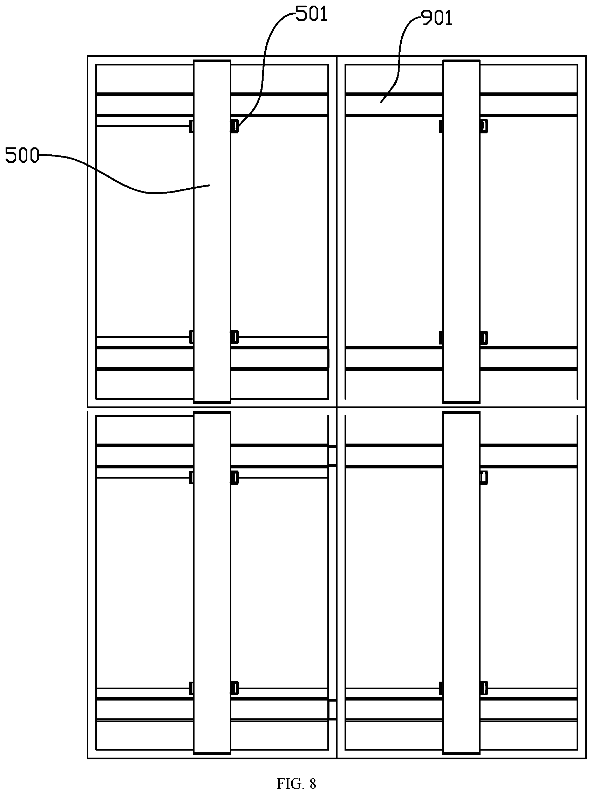

In one embodiment, please refer to FIG. 8 to FIG. 10, a joint kit 901 is disposed between the adjacent frame type box bodies 400, the joint kit 901 penetrates through side walls of two adjacent frame type box bodies 400, and the joint kit 901 is provided with a through hole penetrating through the two adjacent frame type box bodies 400; and the joint kit 901 is made of a conductive material and electrically connected to the frame type box body 400.

Specifically, the present embodiment does not limit a specific form of the joint kit 901, and the joint kits 901 that can enclose a cable between the adjacent frame type box bodies 400 and prevent signal leakage should be both within the scope of protection of the present embodiment. Exemplarily, the joint kit 901 and the system electronic control box are disposed in a length direction or a width direction of the LED screen, several conduits 900 which are vertically disposed with the system electronic control box are connected to the system electronic control box, and the joint kits 901 are disposed on an end portion of the system electronic control box and an end portion of the conduit 900. The joint kit 901 disposed on the end portion of the system electronic control box is passed into the system electronic control box in the adjacent frame type box bodies 400, so as to avoid the exposure of the cable. The joint kit 901 disposed on the end portion of the conduit 900 is a part of the conduit 900, extends from the end portion of the conduit 900 and stretches into the conduit 900 of the adjacent frame type box bodies 400, which realizes complete encirclement of the cable, thereby avoiding signal leakage.

In the present embodiment, by disposing the joint kit 901, a line between the adjacent frame type box bodies 400 is wrapped and protected, and the joint kit 901 penetrates from one frame type box body 400 into another frame type box body 400 and forms an electrical connection structure with the frame type box body 400, thereby forming an equipotential body with the frame type box body 400, further preventing signal leakage at a cable joint, and further providing a safeguard for data security.

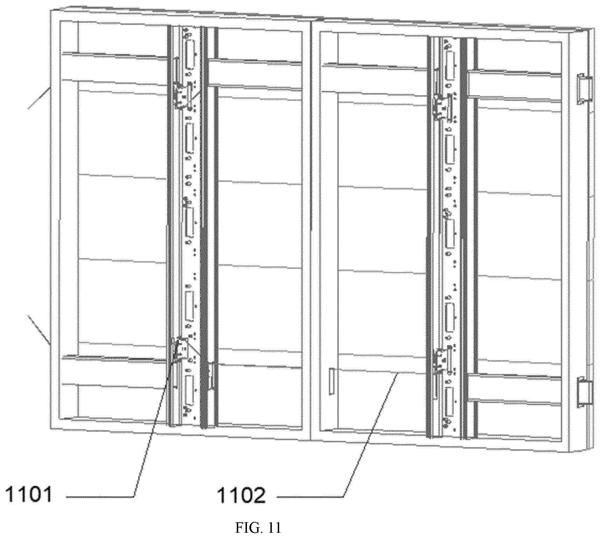

In one embodiment, please refer to a structural schematic view of an LED module for preventing signal leakage of FIG. 11. The LED display screen is formed by assembling by NxM (both N and M are positive rational numbers) LED modules, and a set of connection device is mounted in left and right adjacent LED modules. The connection device is mounted on a connector of the microswitch in the system electronic control box. The connection device is an externally insulated high-strength flexible connecting device, such as a rubber-coated steel wire rope.

According to an embodiment of the present application, in another aspect, the present application further provides an LED dome screen, including a plurality of frame type box bodies 400, a frame plane of the frame type box bodies 400 being curved, the plurality of frame type box bodies 400 being mutually spliced in an array type to form a curved surface-shaped display screen frame, and a length of a long side of the display screen frame being greater than or equal to 3 meters; and the above LED module, a plurality of LED modules being disposed and respectively connected to the frame type box body 400, the supporting structure 200 being provided with a compressible conductive medium electrically connected to the second conductive layer 202, and the compressible conductive medium abutting against the frame type box body 400.

According to an embodiment of the present application, in another aspect, the present application further provides an LED cambered screen, including a mounting frame and a plurality of the above LED modules, the plurality of the LED modules being all mounted on the mounting frame and arranged in a cambered surface shape.

In the present embodiment, the LED modules are arranged in the cambered surface shape to form the cambered screen, which further enhances the diversity of screen use scenarios and applicable sites, and improves the practicality of the product.

Although the embodiments of the present application are described with reference to the accompanying drawings, a person skilled in the art may make various modifications and variations without departing from the spirit and scope of the present application, and such modifications and variations fall within the scope limited by the appended claims.

## Claims

1. An LED module, **characterized in that** it comprises:
a printed circuit board (100), one side of the printed circuit board (100) being provided with a plurality of LED light-emitting diodes (101), the printed circuit board (100) being provided with a plurality of first through channels (103), an inner peripheral side wall of the first through channel (103) being provided with a first conductive layer (104), both sides of the printed circuit board (100) being respectively provided with a conductive edge (105) corresponding to the first through channel (103), the conductive edge (105) being laid in a direction from the periphery to the first through channel (103), extending to the first conductive layer (104) and being electrically connected to the first conductive layer (104), and the first conductive layer (104) being disposed in a grounding manner; and
a supporting structure (200), which is suitable for supporting the printed circuit board (100) and has a plurality of second through channels (201) opposite to the first through channel (103) one to one, the supporting structure (200) having a second conductive layer (202), and the second conductive layer (202) being grounded and abutting against the conductive edge (105).

2. The LED module according to claim 1, **characterized in that** the supporting structure (200) is made of a conductive material to form the second conductive layer (202), or the surface of the supporting structure (200) is metallized to form the second conductive layer (202).

3. The LED module according to claim 1 or 2, **characterized in that** the LED module further comprises a mask layer (300), the mask layer (300) is integrally disposed with the printed circuit board (100) and located on a side of the printed circuit board (100) away from the supporting structure (200), the first through channel (103) extends and penetrates through the mask layer (300), the mask layer (300) is made of a conductive material and electrically connected to the first conductive layer (104), and the LED light-emitting diode (101) passes through the mask layer (300).

4. The LED module according to any of the claims 1 to 3, **characterized in that** the LED module further comprises a mask layer (300), the mask layer (300) is located on a side of the printed circuit board (100) away from the supporting structure (200) and tightly connected to the printed circuit board (100), the mask layer (300) has a plurality of third through channels (301) opposite to the first through channel (103) one to one, the mask layer (300) has a third conductive layer (302), the third conductive layer (302) is grounded and abuts against the conductive edge (105), and the mask layer (300) is provided with an avoiding groove (303) for the LED light-emitting diode (101) to pass through.

5. The LED module according to claim 4, **characterized in that** the mask layer (300) is made of a metal material to form the third conductive layer (302), or the surface of the mask layer (300) is metallized to form the third conductive layer (302).

6. The LED module according to claim 5, **characterized in that** the printed circuit board (100) is provided with a plurality of connection contacts (106), the plurality of connection contacts (106) are distributed on a board face of one side of the printed circuit board (100), or the plurality of connection contacts (106) are distributed on board faces of both sides of the printed circuit board (100), and the connection contact (106) is suitable for abutting against the second conductive layer (202) or the third conductive layer (302).

7. The LED module according to any one of claims 1 to 6, **characterized in that** a sectional shape of the first through channel (103) is one of or a combination of a circle, a polygon, an ellipse, and a kidney shape.

8. The LED module according to claim 7, **characterized in that** a ratio of a total area of the plurality of the first through channels (103) to an area of the printed circuit board (100) is 1%-30%.

9. The LED module according to any of the claims 1 to 8, **characterized in that** a side of the printed circuit board (100) deviating from the LED light-emitting diode (101) is provided with a driving element (102) of the LED light-emitting diode (101), the supporting structure (200) is provided with an accommodating groove (203) at a position opposite to the driving element (102), and the accommodating groove (203) and the printed board (100) form an isolation space surrounding the driving element (102).

10. The LED module according to claim 9, **characterized in that** a first trigger switch is disposed between the supporting structure (200) and the printed circuit board (100).

11. An LED display screen, **characterized in that** it comprises:
a plurality of frame type box bodies (400), the frame type box body (400) being a metal frame and disposed in a grounding manner, the plurality of frame type box bodies (400) being mutually spliced in an array shape to form a display screen frame, and a length of a long side of the display screen frame being greater than or equal to 3 meters;
a system electronic control box (500), which is mounted on an inner side of the frame type box body (400); and
the LED module according to any one of claims 1 to 10, a plurality of LED modules being disposed and respectively connected to the frame type box body (400), the supporting structure (200) being provided with a compressible conductive medium electrically connected to the second conductive layer (202), and the compressible conductive medium abutting against the frame type box body (400).

12. The LED display screen according to claim 11, **characterized in that** the system electronic control box (500) comprises a box cover (503) and a box body (502) which are hinged to each other, a safety prying-resistant lock (501) is disposed between the box cover (503) and the box body (502), and a second trigger switch (800) is provided.

13. The LED display screen according to claim 11 or 12, **characterized in that** a connection device is mounted in left and right adjacent LED modules, and the connection device is mounted on a connector of the microswitch in the system electronic control box.

14. An LED dome screen, **characterized in that** it comprises:
a plurality of frame type box bodies (400), a frame plane of the frame type box body (400) being in a hyperboloid shape, and the plurality of frame type box bodies (400) being mutually spliced in an array shape to form a spherical display screen frame, and a diameter of the LED dome screen being greater than or equal to 3 meters; and
the LED module according to any one of claims 1 to 10, a plurality of LED modules being disposed and respectively connected to the frame type box body (400), the supporting structure (200)being provided with a compressible conductive medium electrically connected to the second conductive layer (202), and the compressible conductive medium abutting against the frame type box body (400).

15. An LED cambered screen, **characterized in that** it comprises:
a mounting frame; and
a plurality of LED modules according to any one of claims 1 to 10, the plurality of LED modules being all mounted on the mounting frame and arranged in a cambered surface shape.
